# EUROPÄISCHE PATENTSCHRIFT

(11) **EP 4 331 002 B1**
(45) Veröffentlichungstag und Bekanntmachung des Hinweises auf die Patenterteilung: **30.04.2025**
(21) Anmeldenummer: 22716911.7
(22) Anmeldetag: 18.03.2022
(51) Int. Cl.: H01J 37/32, H05H 1/48

(54) **HOHLKATHODENSYSTEM ZUM ERZEUGEN EINES PLASMAS UND VERFAHREN ZUM BETREIBEN EINES SOLCHEN HOHLKATHODENSYSTEMS**
HOLLOW CATHODE SYSTEM FOR GENERATING A PLASMA AND METHOD FOR OPERATING SUCH A HOLLOW CATHODE SYSTEM
SYSTÈME DE CATHODE CREUSE POUR GÉNÉRER UN PLASMA ET PROCÉDÉ DE FONCTIONNEMENT D'UN TEL SYSTÈME DE CATHODE CREUSE

(30) Priorität: 29.04.2021 DE 102021111097
(43) Veröffentlichungstag der Anmeldung: 06.03.2024
(73) Patentinhaber: Fraunhofer-Gesellschaft zur Förderung der angewandten Forschung e.V., 80686 München (DE)
(72) Erfinder: FLASKE, Henrik, 01277 Dresden (DE); BJÖRN, Meyer, 01277 Dresden (DE); GÖSTA, Mattausch, 01277 Dresden (DE); WEISS, Stefan, 01277 Dresden (DE); KIRCHHOFF, Volker, 01277 Dresden (DE); ZIMMERMANN, Burkhard, 01277 Dresden (DE); LABITZKE, Rainer, 01277 Dresden (DE); KUBUSCH, Jörg, 01277 Dresden (DE)
(86) Internationale Anmeldenummer: PCT/EP2022/057255
(87) Internationale Veröffentlichungsnummer: WO 2022/228778

(56) Entgegenhaltungen:
- EP-A1- 1 177 714
- EP-A1- 3 520 131
- WO-A1-2010/099218
- WO-A1-2013/091927
- CN-U- 209 237 668
- DE-A1- 102013 106 315
- DE-A1- 102013 210 155
- DE-A1- 102014 110 835
- DE-A1- 19 902 146
- DE-A1- 19 958 016

## Beschreibung

Die Erfindung betrifft ein Hohlkathodensystem zum Erzeugen eines Plasmas, welches zum Beispiel beim Beschichten oder Bearbeiten von Substratoberflächen unter Vakuumbedingungen zur Anwendung gelangt, sowie ein Verfahren zum Betreiben eines solchen Hohlkathodensystems.

Hohlkathoden-Plasmaquellen werden für vielfältige Aufgaben genutzt, wie zum Beispiel bei der Plasmaaktivierung von PVD-Prozessen, beim Anregen von PECVD-Prozessen, beim Entschichten, Reinigen oder physikalisch-chemischen Modifizieren von Oberflächen, beim Realisieren von Bogenverdampfern oder auch als Heizquelle. Das Funktionsprinzip einer Hohlkathodenentladung besteht in einer besonders effizienten Plasmaanregung zwischen einander zugeneigten Kathodenflächen, deren Zwischenraum von einem Arbeitsgas durchströmt wird (DE 10 2010 011 592 A1 und DE 10 2013 210155 A1). Ionen aus der Plasmazone beaufschlagen die Kathodeninnenwandung und sorgen so für das Bereitstellen von Elektronen per Sekundärelektronenemission (Hohlkathoden-Glimmentladung) bzw. per thermionische Elektronenemission (Hohlkathoden-Bogenentladung) für die Entladung, womit allerdings verschiedene Verschleißmechanismen einhergehen. Der Ionenbeschuss sorgt bei beiden Entladungstypen für das kontinuierliche Zerstäuben von Hohlkathoden (Sputtereffekt). Im Falle einer Bogenentladung, bei der die Hohlkathoden typischerweise rohrförmig ausgebildet sind, kommen durch die hohen Betriebstemperaturen erhöhte Sputterraten, Abdampfung, Umkristallisation sowie Versprödung von Material und auch chemisch assistierter Abtrag bei reaktiven Prozessen während des Betriebs hinzu. Daneben ist aber auch die Zündphase besonders verschleißträchtig, da hierbei häufig eine Materialverspritzung durch kalte Bögen auftritt. Die Lebensdauer derartiger Plasmaquellen beträgt deshalb (je nach Betriebscharakteristik und Prozessbedingungen) nur wenige Stunden. Für einen industrieüblichen kontinuierlichen Betrieb über eine, mitunter auch zwei Wochen ist dies viel zu kurz. Generell bedeutet die kurze Kathodenlebensdauer einen hohen Zeitverlust, da der Wechsel der Verschleißteile die Unterbrechung des Prozesses sowie das Belüften der Prozesskammer erfordert (Kontamination der Prozessumgebung), was zudem anschließend eine Re-Konditionierung notwendig macht. Das Magazinieren mehrerer kompletter Plasmaquellen sowie das vakuumtechnische Entkoppeln derselben vom Prozessraum durch Schieberventile wäre extrem aufwändig sowie kostspielig und stellt daher keine wirtschaftliche Option dar.

Neben der Verschleiß- bzw. Lebensdauerproblematik ist auch das Aufskalieren der Plasmaleistung ein weiteres Problem. Der Entladungsstrom bei einer Hohlkathoden-Bogenentladung ist durch die maximal erreichbare Emissionsstromdichte des Hohlkathodenmaterials vor Erreichen der Schmelztemperatur sowie durch die limitierte Emissionsfläche - die Entladung konzentriert sich auf eine sogenannte aktive Zone, also auf einen bestimmten axialen Bereich der Hohlkathode, wo Arbeitsgasdruck und freie Weglängen der Plasmaelektronen gut zueinander passen - beschränkt. Daher kann eine deutliche Erhöhung der Entladungsleistung im Allgemeinen nicht durch höhere Belastung einer Hohlkathodenquelle erreicht werden, sondern nur durch eine kostspielige Implementation mehrerer parallel zu betreibender Plasmaquellen.

Aus DE 10 2006 027 853 A1 ist ein Hohlkathodensystem bekannt, bei welchem ein Kathodenröhrchen, zumindest an dem Ende der Gasaustrittsöffnung, von einer ringförmigen Anode und einer ringförmigen Magnetspule umschlossen ist. Mittels einem derartigen Hohlkathodensystem kann eine höhere Plasmaintensität gegenüber herkömmlichen Hohlkathoden-Plasmaquellen erzielt werden. WO 2013/091927 A1 offenbart Plasmaquellen, welche zwei Hohlkathoden umfasst, wobei die Austrittsöffnungen der beiden Hohlkathoden einander zugewandt sind. Zwischen die beiden Hohlkathoden ist eine Stromversorgungseinrichtung geschaltet, welche eine Wechselspannung bereitstellt, so dass die beiden Hohlkathoden abwechselnd als Kathode bzw. Anode einer Hohlkathoden-Bogenentladung fungieren. Auch mit einer solchen Plasmaquelle lässt sich zwischen den beiden Hohlkathoden ein intensiveres Plasma erzeugen gegenüber einer Plasmaquelle mit nur einer Hohlkathode. Jedoch ist auch bei den zuvor beschriebenen beiden Hohlkathodensystemen die Betriebszeit durch die Lebenszeit eines Kathodenröhrchens limitiert.

Ein drittes Problem bei Hohlkathodensystemen liegt im immensen Materialaufwand für die Verschleißteile. Die häufig zu wechselnden Hohlkathoden werden stets als Ganzes gewechselt, obwohl sich der Verschleiß im Wesentlichen nur auf die aktive Zone konzentriert.

Der Erfindung liegt daher das technische Problem zugrunde, ein Hohlkathodensystem zum Erzeugen eines Plasmas und ein Verfahren zum Betreiben eines solchen Hohlkathodensystems zu schaffen, mittels derer die Nachteile aus dem Stand der Technik überwunden werden können. Insbesondere soll es mittels eines erfindungsgemäßen Hohlkathodensystems und mittels eines erfindungsgemäßen Verfahrens möglich sein, eine längere Betriebsdauer gegenüber dem Stand der Technik zu ermöglichen. Des Weiteren soll es mittels eines erfindungsgemäßen Hohlkathodensystems und mittels eines erfindungsgemäßen Verfahrens möglich sein, die Stärke eines mittels eines erfindungsgemäßen Hohlkathodensystems erzeugten Plasmas zu verändern.

Die Lösung des technischen Problems ergibt sich durch Gegenstände mit den Merkmalen der Patentansprüche 1 und 6. Weitere vorteilhafte Ausgestaltungen der Erfindung ergeben sich aus den abhängigen Ansprüchen.

Ein erfindungsgemäßes Hohlkathodensystem zum Erzeugen eines Plasmas gehört zu jener Gattung von Vorrichtungen, bei welchen mittels einer Stromversorgungseinrichtung eine elektrische Spannung zwischen einem Kathodenröhrchen und einer Anodeneinrichtung angelegt ist. Wird gleichzeitig das Kathodenröhrchen von einem Arbeitsgas durchströmt, welches in einem ersten Gasreservoir bereitgestellt ist, kann eine Bogenentladung zwischen dem Kathodenröhrchen und der Anodeneinrichtung innerhalb einer Vakuumkammer ausgebildet werden. Ein erfindungsgemäßes Hohlkathodensystem zeichnet sich dadurch aus, dass dieses mindestens zwei Kathodenröhrchen aufweist, welche elektrisch leitfähig miteinander verbunden sind. Bevorzugt weisen die Kathodenröhrchen einen kreisrunden Innenquerschnitt auf. Der Innenquerschnitt der Kathodenröhrchen bei einem erfindungsgemäßen Hohlkathodensystem kann aber alternativ eine beliebige andere geometrische Figur aufweisen. Ein elektrisch leitfähiger Kontakt zwischen den einzelnen Kathodenröhrchen kann beispielsweise mittels Kontaktelementen oder, wenn die Kathodenröhrchen aneinandergrenzend angeordnet sind, auch durch einen Berührungskontakt ausgebildet werden. Alle Kathodenröhrchen eines erfindungsgemäßen Hohlkathodensystems weisen somit immer das gleiche elektrische Spannungspotenzial auf. Ferner ist bei einem erfindungsgemäßen Hohlkathodensystem jedem Kathodenröhrchen ein separates Stellglied zugeordnet, mittels dessen die Menge des im ersten Gasreservoir bereitgestellten Gases und/oder die Art des Gases, welches das dem Stellglied zugeordnete Kathodenröhrchen durchströmt, einstellbar ist.

Dadurch, dass jedem Kathodenröhrchen ein separates Stellglied für das Einstellen der Menge des das Kathodenröhrchen durchströmenden Gases zugeordnet ist, kann auch von jedem Kathodenröhrchen separat eine Hohlkathodenbogenentladung zur Anodeneinrichtung gezündet werden. Jedem Kathodenröhrchen eines erfindungsgemäßen Hohlkathodensystems ist dabei ein und dieselbe Anodeneinrichtung zum Ausbilden einer Hohlkathodenbogenentladung zugeordnet. Aus dem Stand der Technik ist es bekannt, dass man durch das Platzieren mehrerer Anodenelemente innerhalb einer Vakuumkammer die Form eines Plasmas gestalten kann. Die Anodeneinrichtung eines erfindungsgemäßen Hohlkathodensystems kann daher bei einer Ausführungsform auch mehrere Anodenelemente umfassen. Bei einer weiteren Ausführungsform ist ein Element der Anodeneinrichtung ringförmig ausgebildet, welches alle Kathodenröhrchen zumindest an der Seite der Kathodenröhrchen-Gasaustrittsöffnung umschließt.

Aus dem Stand der Technik ist es bekannt, dass üblicherweise Hilfseinrichtungen zum Zünden einer Hohlkathode verwendet werden, wie zum Beispiel eine Heizwendel, welche um eine Hohlkathode gewickelt ist und welche an eine zugehörige Stromversorgungseinrichtung zum Bereitstellen einer elektrischen Heizspannung angeschlossen ist. Derartige Hilfseinrichtungen können auch Magnetfeldspulen oder Permanentmagnete zum Erzeugen eines Magnetfeldes in und um eine Hohlkathode herum oder auch eine Einrichtung zum Erzeugen von Hochspannungspulsen zwischen Hohlkathode und Anodeneinrichtung umfassen. Auch jedem Kathodenröhrchen eines erfindungsgemäßen Hohlkathodensystems kann eine solche Hilfseinrichtung zum Zünden einer Bogenentladung zugeordnet sein. Dabei kann jede Hilfseinrichtung verwendet werden, die auch im Stand der Technik zum Zünden einer Hohlkathodenbogenentladung verwendet wird.

Es wurde bereits dargelegt, dass bei einem erfindungsgemäßen Hohlkathodensystem ausgehend von jedem Kathodenröhrchen eine separate Bogenentladung gezündet und aufrechterhalten werden kann, so dass mittels jedes Kathodenröhrchens auch ein Plasma ausgebildet werden kann. Dabei sollen alle Plasmen, welche mittels der einzelnen Kathodenröhrchen ausgebildet werden, möglichst das gleiche Volumen durchdringen.

Bei einer Ausführungsform sind daher die Rohrachsen der mindestens zwei Kathodenröhrchen parallel zueinander ausgerichtet oder weisen einen Winkel von maximal 5° zueinander auf, wobei das Gas aus dem Gasreservoir mit der gleichen Gasflussrichtung durch die mindestens zwei Kathodenröhrchen strömt.

Damit die Plasmen, welche mittels der mindestens zwei Kathodenröhrchen erzeugt werden, möglichst das gleiche Volumen durchdringen, ist es auch vorteilhaft, wenn benachbarte Kathodenröhrchen einen Abstand von maximal 20 mm zueinander aufweisen.

Ein erfindungsgemäßes Verfahren zum Betreiben eines Hohlkathodensystems, bei welchem eine Anodeneinrichtung, eine Stromversorgungseinrichtung zum Bereitstellen einer zwischen dem Kathodenröhrchen und der Anodeneinrichtung geschalteten elektrischen Spannung und mindestens ein erstes Gasreservoir zum Bereitstellen eines das Kathodenröhrchen durchströmenden Gases verwendet werden, zeichnet sich dadurch aus, dass mindestens zwei Kathodenröhrchen verwendet werden, welche elektrisch leitfähig miteinander verbunden werden und wobei jedem Kathodenröhrchen ein separates Stellglied zugeordnet wird, mittels dessen die Menge und/oder die Art des Gases, welches das dem jeweiligen Stellglied zugeordnete Kathodenröhrchen durchströmt, eingestellt wird.

Dabei kann ein erfindungsgemäßes Hohlkathodensystem im Wesentlichen in zwei Modi betrieben werden. Bei einem ersten Betriebsmodus wird eine Bogenentladung mittels mindestens eines ersten Kathodenröhrchens gezündet uns so lange aufrechterhalten, bis zum Beispiel die Lebensdauer des mindestens einen ersten Kathodenröhrchens abgelaufen ist. Hierzu wird zumindest bei dem einen ersten Kathodenröhrchen mittels eines ersten Stellgliedes eine das erste Kathodenröhrchen durchströmende erste Gasmenge eingestellt, welche zum Zünden und Aufrechterhalten einer Bogenentladung zwischen dem ersten Kathodenröhrchen und der Anodeneinrichtung geeignet ist. Wenn das mindestens eine erste Kathodenröhrchen verschlissen bzw. dessen Lebensdauer abgelaufen ist, wird die Bogenentladung vom ersten Kathodenröhrchen gelöscht und anschließend eine Bogenentladung ausgehend von mindestens einem zweiten Kathodenröhrchen gezündet. Auf diese Weise kann die Betriebsdauer eines erfindungsgemäßen Hohlkathodensystems gegenüber dem Stand der Technik, bei welchem nach dem Verschleiß einer Hohlkathode eine Vakuumkammer geöffnet und die Hohlkathode ausgetauscht werden muss, verlängert werden. Bei der zuvor beschriebenen Vorgehensweise wird einem Kathodenröhrchen einmalig eine Bogenentladung gezündet und so lange aufrechterhalten, bis die Betriebszeit des Kathodenröhrchens abgelaufen ist. Alternativ können die beteiligten Kathodenröhrchen auch jeweils abwechselnd, nacheinander in Teilzyklen bezüglich der Lebensdauer aktiviert werden, so dass alle beteiligten Kathodenröhrchen einen immer annähernd gleichen Verschleißzustand aufweisen, was sich positiv auf das Aufrechterhalten homogener Prozessbedingungen auswirkt.

Beim zweiten Betriebsmodus eines erfindungsgemäßen Hohlkathodensystems geht es vornehmlich nicht um das Verlängern dessen Betriebsdauer, sondern um das Verändern der Stärke eines Plasmas, welches mittels des Hohlkathodensystems erzeugt wird. Es wurde ja bereits dargelegt, dass die Plasmen der einzelnen Kathodenröhrchen eines erfindungsgemäßen Hohlkathodensystems im Wesentlichen das gleiche Volumen innerhalb einer Vakuumkammer durchdringen. Durch das zusätzliche Aktivieren eines zweiten Kathodenröhrchens, wenn bereits mindestens eine Bogenentladung von einem ersten Kathodenröhrchen brennt bzw. durch das Deaktivieren eines zweiten Kathodenröhrchens, wenn von mindestens einem ersten und einem zweiten Kathodenröhrchen eine Bogenentladung brennt, kann die Stärke des Plasmas im vom Plasma durchdrungenen Volumen verändert werden. Beim zweiten Betriebsmodus wird somit zumindest zeitweise von mindestens zwei Kathodenröhrchen gleichzeitig eine Bogenentladung hin zur Anodeneinrichtung aufrechterhalten, um ein stärkeres Plasma auszubilden gegenüber dem Fall, dass lediglich von einem Kathodenröhrchen eine Bogenentladung brennt.

Die Erfindung wird nachfolgend anhand von Ausführungsbeispielen näher beschrieben. Die Fig. zeigen:
- Fig. 1: eine schematische Darstellung eines erfindungsgemäßen Hohlkathodensystems;
- Fig. 2a, 2b: eine schematische Schnittdarstellung einer ersten alternativen Kathodenröhrchen-Konfiguration;
- Fig. 3: eine schematische Schnittdarstellung einer zweiten alternativen Kathodenröhrchen-Konfiguration;
- Fig. 4: eine schematische Schnittdarstellung einer dritten alternativen Kathodenröhrchen-Konfiguration;
- Fig. 5: eine schematische Schnittdarstellung einer vierten alternativen Kathodenröhrchen-Konfiguration.

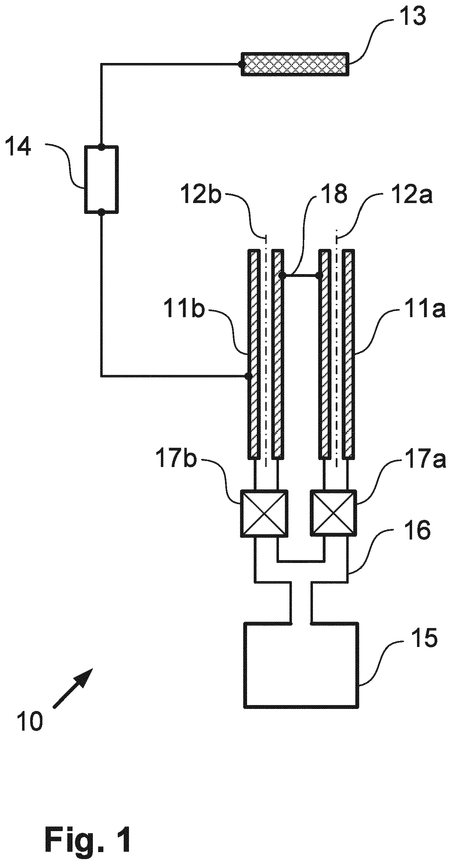

In Fig. 1 ist ein erfindungsgemäßes Hohlkathodensystem 10 schematisch dargestellt. Das Hohlkathodensystem 10 umfasst ein erstes Kathodenröhrchen 11a und ein zweites Kathodenröhrchen 11b, welche mit einem Maß von maximal 20 mm voneinander beabstandet sind. Dabei sind die Rohrachsen 12a und 12b der beiden Kathodenröhrchen 11a und 11b parallel zueinander ausgerichtet. Zum Hohlkathodensystem 10 gehören ferner eine Anodeneinrichtung 13 sowie eine Stromversorgungseinrichtung 14, welche eine elektrische Spannung für das Ausbilden einer Bogenentladung zwischen dem ersten Kathodenröhrchen 11a und/oder dem zweiten Kathodenröhrchen 11b auf der einen Seite und der Anodeneinrichtung 13 auf der anderen Seite bereitstellt. Die beiden Kathodenröhrchen 11a und 11b sowie die Anodeneinrichtung 13 sind innerhalb einer Vakuumkammer angeordnet, welche aus Gründen der Übersichtlichkeit nicht in Fig. 1 dargestellt ist.

Während des Betriebes des Hohlkathodensystems 10 strömt ein Arbeitsgas in gleicher Strömungsrichtung durch das erste Kathodenröhrchen 11a und/oder durch das zweite Kathodenröhrchen, wobei das Arbeitsgas in einem ersten Gasreservoir 15 bereitgestellt ist und mittels Gasleitungen 16 vom Gasreservoir zu den Kathodenröhrchen 11a und 11b geführt wird. Dabei sind dem ersten Kathodenröhrchen 11a ein erstes Stellglied 17a und dem zweiten Kathodenröhrchen 11b ein zweites Stellglied 17b zugeordnet. Mittels der Stellglieder 17a und 17b kann die Menge des Gases, welches durch ein einem jeweiligen Stellglied zugeordnetes Kathodenröhrchen strömt, separat eingestellt werden. Die beiden Kathodenröhrchen 11a und 11b sind mittels eines Kontaktelements 18 elektrisch leitfähig miteinander verbunden und weisen somit ständig ein gleiches elektrisches Spannungspotenzial auf. Das Kontaktelement 18 kann zum Beispiel auch als Sockelelement aus einem elektrisch leitfähigen Material ausgebildet sein, in welches die Kathodenröhrchen 11a und 11b hineingeschraubt werden. Auf das Kontaktelement 18 kann verzichtet werden, wenn die beiden Kathodenröhrchen 11a und 11b so dicht nebeneinander angeordnet werden, dass zumindest ein dauerhafter Berührungskontakt zwischen den beiden Kathodenröhrchen ausgebildet wird. Mittels der beiden Stellglieder 17a und 17b kann somit beim dem Hohlkathodensystem 10 ausgehend von jedem der beiden Kathodenröhrchen 11a und 11b separat eine Bogenentladung hin zur Anodeneinrichtung 13 ausgebildet werden.

Bei einer ersten Verfahrensvariante wird zunächst mittels des ersten Stellgliedes 17a eine das erste Kathodenröhrchen 11a durchströmende Gasmenge eingestellt, welche zum Ausbilden einer Bogenentladung zwischen dem ersten Kathodenröhrchen 11a und der Anodeneinrichtung 13 geeignet ist. Es wird somit eine Bogenentladung zwischen dem ersten Kathodenröhrchen 11a und der Anodeneinrichtung 13 gezündet und aufrechterhalten. Ein Kathodenröhrchen, welches am Ausbilden einer Bogenentladung beteiligt ist, wird nachfolgend auch als aktiviertes Kathodenröhrchen bezeichnet. Wird, wie zuvor dargelegt, eine Bogenentladung vom ersten Kathodenröhrchen 11a zur Anodeneinrichtung 13 ausgebildet, ist somit zunächst einmal nur das Kathodenröhrchen 11a ein aktiviertes Kathodenröhrchen, während Kathodenröhrchen 11b inaktiv ist. Ein oder mehrere in der Vakuumkammer angeordnete Substrate können somit zunächst einmal unter Mitwirkung des vom ersten Kathodenröhrchen 11a erzeugten Plasmas bearbeitet werden. Wenn die Lebensdauer bzw. die Betriebszeit des ersten Kathodenröhrchens 11a verstrichen ist, wird zunächst die Bogenentladung zwischen dem ersten Kathodenröhrchen 11a und der Anodeneinrichtung 13 gelöscht. Anschließend wird mittels des zweiten Stellgliedes 17b eine das zweite Kathodenröhrchen 11b durchströmende Gasmenge eingestellt, welche zum Ausbilden einer Bogenentladung zwischen dem zweiten Kathodenröhrchen 11b und der Anodeneinrichtung 13 geeignet ist, eine entsprechende Bogenentladung gezündet und aufrechterhalten, so dass der Bearbeitungsprozess eines oder mehrerer Substrate innerhalb der Vakuumkammer unter der Mitwirkung des mittels des zweiten Kathodenröhrchens 11b erzeugten Plasmas fortgesetzt werden kann. Auf diese Weise kann die Betriebszeit eines Hohlkathodensystems gegenüber dem Stand der Technik verlängert werden, ohne die Vakuumkammer öffnen zu müssen. Alternativ können die Kathodenröhrchen 11a und 11b auch abwechseln, nacheinander in Teilzyklen aktiviert werden, damit die Kathodenröhrchen 11a und 11b immer einen annähernd gleichen Verschleißzustand aufweisen. Bevorzugt wird ein zweites Kathodenröhrchen erst dann aktiviert, nachdem ein erstes Kathodenröhrchen deaktiviert wurde. Alternativ kann ein zweites Kathodenröhrchen aber auch vor oder mit dem Deaktivieren eines ersten Kathodenröhrchens aktiviert werden.

Bei einer zweiten Verfahrensvariante wird, wie auch zuvor schon bei der ersten Verfahrensvariante beschrieben, zunächst mittels des ersten Stellgliedes 17a eine das erste Kathodenröhrchen 11a durchströmende Gasmenge eingestellt, welche zum Ausbilden einer Bogenentladung zwischen dem ersten Kathodenröhrchen 11a und der Anodeneinrichtung 13 geeignet ist. Es wird somit zunächst lediglich das erste Kathodenröhrchen 11a aktiviert und dadurch ein Plasma generiert, unter dessen Mitwirkung ein oder mehrere Substrate innerhalb der Vakuumkammer bearbeitet werden können. Zu einem späteren Zeitpunkt, wenn für das Bearbeiten von Substraten innerhalb der Vakuumkammer ein stärkeres Plasma erforderlich ist, wird mittels des zweiten Stellgliedes 17b eine das zweite Kathodenröhrchen 11b durchströmende Gasmenge eingestellt, welche zum Ausbilden einer Bogenentladung zwischen dem zweiten Kathodenröhrchen 11b und der Anodeneinrichtung 13 geeignet ist, wodurch eine zusätzliche Plasmawolke erzeugt wird. Dabei ist für jedes Kathodenröhrchen die Stromstärke für das Aufrechterhalten einer jeweiligen Bogenentladung separat einstellbar. Da sich aufgrund der unmittelbaren Nähe der beiden Kathodenröhrchen 11a und 11b zueinander deren Plasmawolken zumindest teilweise durchdringen, kann ein Gesamtplasma mit höherer Leistung erzeugt werden. Wird zu einem späteren Zeitpunkt ein Plasma mit geringerer Leistung benötigt, kann die Bogenentladung von einem der beiden zu diesem Zeitpunkt aktivierten Kathodenröhrchen 11a und 11b gelöscht werden.

Bei dem zu Fig. 1 beschriebenen Ausführungsbeispiel eines erfindungsgemäßen Hohlkathodensystems umfasst die Kathodenröhrchen-Konfiguration insgesamt zwei Kathodenröhrchen. Bei einem erfindungsgemäßen Hohlkathodensystem kann jedoch auch eine Kathodenröhrchen-Konfiguration verwendet werden, welche mehr als nur zwei Kathodenröhrchen umfasst. Dabei sind der Anzahl der Kathodenröhrchen nach oben hin keine Grenzen gesetzt. Erfindungswesentlich hierbei ist lediglich, dass die Kathodenröhrchen elektrisch leitfähig miteinander verbunden sind und direkt benachbarte Kathodenröhrchen einen Abstand von maximal 20 mm zueinander aufweisen.

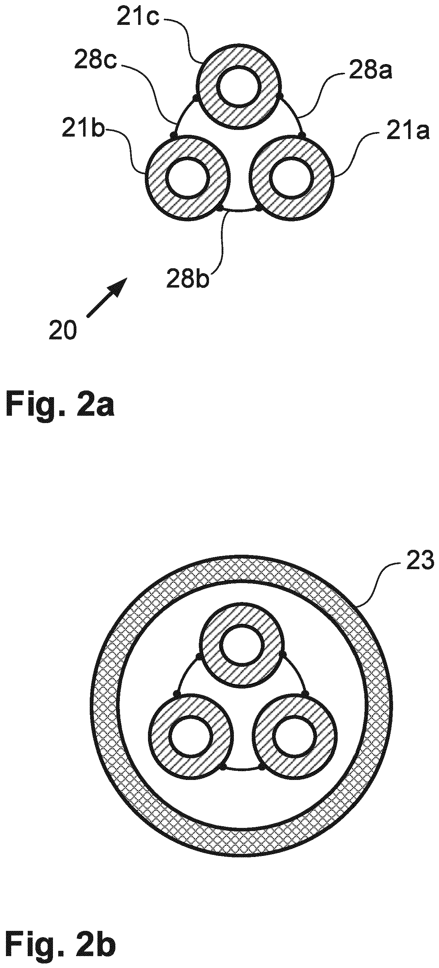

In Fig. 2a ist eine beispielhafte erfindungsgemäße Kathodenröhrchen-Konfiguration 20 schematisch im Querschnitt dargestellt, welche drei Kathodenröhrchen 21a bis 21c aufweist. Die Kathodenröhrchen 21a bis 21c sind mittels Kontaktelementen 28a bis 28c elektrisch leitfähig miteinander verbunden. Wie schon zu der Vorrichtung 10 aus Fig. 1 beschrieben, ist erfindungsgemäß jedem der Kathodenröhrchen 21a bis 21c ein separates Stellglied zugeordnet, mit welchem der Gasfluss durch ein zugeordnetes Kathodenröhrchen separat geregelt werden kann. Somit kann von jedem der Kathodenröhrchen 21a bis 21c auch separat eine Bogenentladung hin zu einer Anodeneinrichtung ausgebildet werden, so dass auch ein erfindungsgemäßes Hohlkathodensystem mit einer Kathodenröhrchen-Konfiguration 20 in den beiden Verfahrensvarianten betrieben werden kann, welche vorhergehend zu dem Ausführungsbeispiel gemäß Fig. 1 beschrieben sind. Gleiches gilt auch für erfindungsgemäße Hohlkathodensysteme mit allen nachfolgend beschriebenen Kathodenröhrchen-Konfigurationen. In Fig. 2b ist die aus Fig. 2a bekannte Kathodenröhrchen-Konfiguration 20 noch einmal im Querschnitt schematisch dargestellt. Bei der Ausführungsform gemäß Fig. 2b wird die Kathodenröhrchen-Konfiguration 20 zumindest an dem Ende der Kathodenröhrchen, an welchen sich die Austrittsöffnung der Kathodenröhrchen befindet, von einem ringförmigen Element 23 der zu den Kathodenröhrchen zugehörigen Anodeneinrichtung umschlossen. Mittels einer derart angeordneten ringförmigen Anode kann ein Kathodenröhrchen eines erfindungsgemäßen Hohlkathodensystems auch mit den Verfahren betrieben werden, wie sie beispielsweise in DE 10 2006 027 853 A1 beschrieben sind. Ein ringförmiges Element 23 einer Anodeneinrichtung kann auch bei allen zuvor und nachfolgend beschriebenen Kathodenröhrchen-Konfigurationen zur Anwendung gelangen, wobei das ringförmige Element jeweils alle Kathodenröhrchen einer Kathodenröhrchen-Konfiguration, zumindest an dem Ende der Kathodenröhrchen, an welchen sich die Gasaustrittsöffnung der Kathodenröhrchen befindet, umschließt.

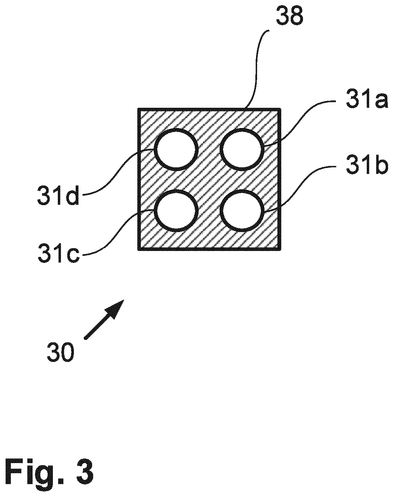

Bei allen zuvor beschriebenen Ausführungsbeispielen sind die Kathodenröhrchen eines erfindungsgemäßen Hohlkathodensystems als separate Röhrchen ausgebildet, welche mittels Kontaktelementen elektrisch leitfähig miteinander verbunden sind. In Fig. 3 ist eine Kathodenröhrchen-Konfiguration 30 schematisch im Querschnitt dargestellt, bei welcher sich durch einen Block 38 aus einem elektrisch leitfähigen Material insgesamt vier zylinderförmige Ausnehmungen 31a bis 31d durch die gesamte Länge des Blocks 38 erstrecken. Die vier Ausnehmungen 31a bis 31d mit ihren zylinderförmigen Mantelflächen des Blocks 38 fungieren hierbei als Kathodenröhrchen, durch welche ein Arbeitsgas zum Ausbilden einer Bogenentladung strömt. Dabei ist jeder Ausnehmung 31a bis 31d ein separates Stellglied zugeordnet, mit welchem der Gasfluss durch eine zugeordnete Ausnehmung separat geregelt werden kann.

Wie zuvor schon einmal aufgezeigt wurde, umfassen Hohlkathodensysteme üblicherweise Hilfseinrichtungen, wie beispielsweise eine Heizwendel mit einer zugehörigen Stromversorgungseinrichtung, mittels denen eine Bogenentladung bei einem Kathodenröhrchen gezündet werden kann. Auch bei allen zuvor beschriebenen Ausführungsbeispielen der Erfindung kann den Kathodenröhrchen eine solche Hilfseinrichtung zum Zünden einer Bogenentladung zugeordnet sein. So kann beispielsweise bei Ausführungsbeispielen, bei denen die Kathodenröhrchen als separate Röhrchen ausgebildet sind, wie bei den Ausführungsbeispielen gemäß der Figuren 1 bis 2b, um jedes Kathodenröhrchen eine separate Heizwendel gewickelt bzw. jedem Kathodenröhrchen ein separates Heizelement zugeordnet sein. Bei dem Ausführungsbeispiel gemäß Fig. 3 kann zum Beispiel eine Heizwendel um den Block 38 gewickelt sein.

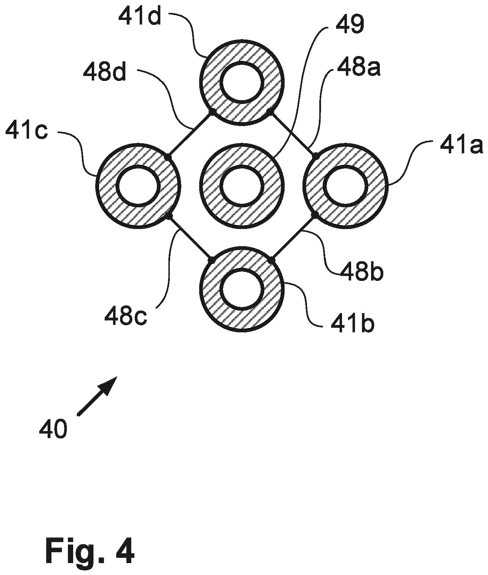

In Fig. 4 ist eine Kathodenröhrchen-Konfiguration 40 schematisch im Querschnitt dargestellt, welche vier Kathodenröhrchen 41a bis 41d umfasst, welche mittels Kontaktelementen 48a bis 48d elektrisch leitfähig miteinander verbunden sind. Mittels der Kathodenröhrchen 41a bis 41d kann entsprechend der zuvor beschriebenen Vorgehensweisen innerhalb einer Vakuumkammer ein Plasma erzeugt werden, mittels dessen mindestens ein Substrat innerhalb der Vakuumkammer bearbeitet werden kann. In der Mitte der vier Kathodenröhrchen 41a bis 41d ist ein weiteres Kathodenröhrchen 49 angeordnet, welches elektrisch isoliert zu den vier Kathodenröhrchen 41a bis 41d ausgebildet ist und welcher eine separate Stromversorgungseinrichtung zum Ausbilden einer Bogenentladung zugeordnet ist. Während des Betriebs eines erfindungsgemäßen Hohlkathodensystems, welches die Kathodenröhrchen-Konfiguration 40 umfasst, wird zunächst vom Kathodenröhrchen 49 eine Bogenentladung gezündet und dadurch ein Plasma generiert. Das mittels des Kathodenröhrchens 49 generierte Plasma wird jedoch mit einer geringeren Intensität ausgebildet als die mittels der Kathodenröhrchen 41a bis 41d ausbildbaren Plasmen. Das mittels des Kathodenröhrchens 49 generierte Plasma ist auch nicht vordergründig beim Bearbeiten eines Substrates involviert, sondern dient hauptsächlich dazu, im Raum zwischen den Kathodenröhrchen und der Anodeneinrichtung Ladungsträger bereitzustellen, die das Zünden mindestens eines der Kathodenröhrchen 41a bis 41d erleichtern.

Weil das mittels des Kathodenröhrchens 49 generierte Plasma nur eine geringe Intensität aufweist, unterliegt das Kathodenröhrchen 49 auch nur einem geringeren Verschleiß gegenüber den Kathodenröhrchen 41a bis 41d. Mittels des Kathodenröhrchens 49 kann daher während der gesamten Betriebszeit eines erfindungsgemäßen Hohlkathodensystems mit Kathodenröhrchen-Konfiguration 40 eine Bogenentladung aufrechterhalten werden, während die Kathodenröhrchen 41a bis 41d nacheinander bzw. abwechselnd aktiviert werden.

Es wurde bereits dargelegt, dass bei einem erfindungsgemäßen Hohlkathodensystem mindestens zwei Kathodenröhrchen beteiligt sind, bei welchem während des Betriebes des Hohlkathodensystems zum Beispiel mindestens ein erstes Kathodenröhrchen aktiviert sein kann, während mindestens ein zweites Kathodenröhrchen inaktiv ist. In der Zeitspanne, in welcher das zweite Kathodenröhrchen inaktiv ist, kann entweder gar kein Gas durch das zweite Kathodenröhrchen strömen oder aber es kann eine geringe Menge eines Gases durch das zweite Kathodenröhrchen strömen, welche nicht geeignet ist, eine Bogenentladung zwischen dem zweiten Kathodenröhrchen und der zugehörigen Anodeneinrichtung auszubilden. Das Durchströmen des zweiten Kathodenröhrchens mit einer geringen Gasmenge gegenüber der Gasmenge, welche für das Ausbilden einer Bogenentladung erforderlich ist, dient hierbei dem Spülen des zweiten Kathodenröhrchens, damit sich das zweite Kathodenröhrchen nicht mit Partikeln zusetzt, welche beispielsweise von dem aktivierten ersten Kathodenröhrchen abgestäubt werden oder welche von einem Beschichtungsmaterial für das Beschichten eines Substrates innerhalb der Vakuumkammer herrühren können. Als Spülgas für ein nicht aktiviertes Kathodenröhrchen kann zum Beispiel das im ersten Gasreservoir bereitgestellte Arbeitsgas verwendet werden, welches auch durch ein Kathodenröhrchen strömt, um eine Bogenentladung auszubilden. Alternativ kann zum Spülen eines Kathodenröhrchens auch ein anderes Gas, vorzugsweise ein Inertgas, verwendet werden, welches in einem zweiten Gasreservoir bereitgestellt wird.

Wenn zum Spülen eines Kathodenröhrchens ein anderes Gas verwendet wird als zum Zünden und Aufrechterhalten einer Bogenentladung, kann die Art des Gases, welches ein jeweiliges Kathodenröhrchen durchströmen soll, beispielsweise mittels des Stellgliedes eingestellt werden, mit dem auch die Gasflussmenge durch ein jeweiliges Kathodenröhrchen eingestellt wird. Alternativ kann die Art des Gases, welches ein jeweiliges Kathodenröhrchen durchströmen soll, auch mittels eines separaten Stellgliedes eingestellt werden.

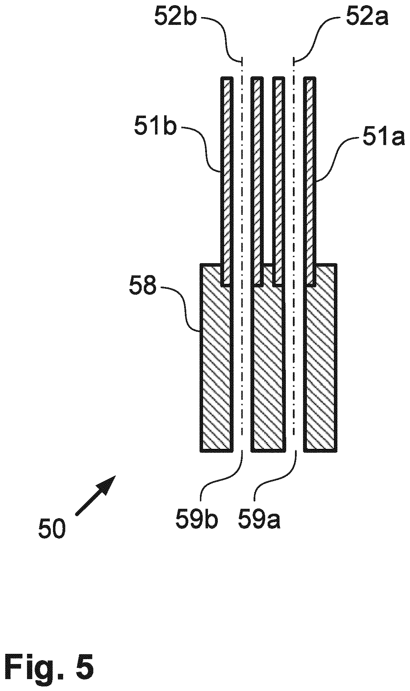

Während bei den Ausführungsbeispielen gemäß der Figuren 1, 2a, 2b und 4 die Kathodenröhrchen als separate Röhrchen und im Ausführungsbeispiel gemäß Fig. 3 als zylinderförmige Ausnehmungen in einem Materialblock ausgebildet sind, ist in Fig. 5 eine Kathodenröhrchen-Konfiguration 50 in einem Längsschnitt schematisch dargestellt, welche eine Mischform aus separaten Kathodenröhrchen und Ausnehmungen eines Materialblocks bildet. Die Kathodenröhrchen-Konfiguration 50 umfasst ein Basiselement 58 aus einem elektrisch leitfähigen Material, bei welchem zwei zylinderförmige Ausnehmungen 59a und 59b herausgearbeitet wurden, welche sich durch die gesamte Länge des Basiselements 58 erstrecken. Die Ausnehmungen 59a und 59b erstrecken sich jedoch nicht über die gesamte Länge, die für ein Kathodenröhrchen benötigt wird. Deshalb sind auch noch Kathodenröhrchen-Teilelemente 51a und 51b derart, vorzugsweise mittels einer lösbaren Verbindung, am Basiselement 58 befestigt, dass die Rohrachse 52a des Kathodenröhrchen-Teilelements 51a und die Zylinderachse der zylinderförmigen Ausnehmung 59a identisch sind sowie die Rohrachse 52b des Kathodenröhrchen-Teilelements 51b und die Zylinderachse der zylinderförmigen Ausnehmung 59b identisch sind. Alternativ können die Zylinderachse einer Ausnehmung und die Rohrachse eines zugehörigen Kathodenröhrchen-Teilelements einen Versatz aufweisen, um zum Beispiel Strahlung jedweder Art aus dem Inneren der Vakuumkammer zu brechen. Als lösbare Verbindung können die Kathodenröhrchen-Teilelemente 51a und 51b zum Beispiel ein Außengewinde aufweisen, welches in das Basiselement 58 hineingeschraubt wird. Somit formen die Ausnehmung 59a und das zugehörige Kathodenröhrchen-Teilelement 51a im Verbund ein erstes Kathodenröhrchen und die Ausnehmung 59b und das zugehörige Kathodenröhrchen-Teilelement 51b ein zweites Kathodenröhrchen. Die Kathodenröhrchen-Konfiguration 50 umfasst lediglich beispielhaft zwei Kathodenröhrchen, kann bei alternativen Ausführungsformen aber auch mehr als nur zwei Kathodenröhrchen umfassen.

Wie zuvor schon einmal dargelegt wurde, vollzieht sich der Verschleiß bei einer Hohlkathode vorwiegend innerhalb einer lokal begrenzten aktiven Zone, welche bei einem Hohlkathodensystem mit einer Kathodenröhrchen-Konfiguration 50 innerhalb der Kathodenröhrchen-Teilelemente 51a und 51b lokalisiert ist. Deshalb brauchen bei einer Kathodenröhrchen-Konfiguration 50 lediglich verschlissene Kathodenröhrchen-Teilelemente ausgewechselt werden und nicht gleich ein gesamtes Kathodenröhrchen, was zu Materialeinsparungen führt. Eine signifikante Materialeinsparung wird hierbei erzielt, wenn die Länge der Ausnehmungen 59a und 59b jeweils mindestens 30 % von dem Maß betragen, welches sich aus der Summe der Längen einer Ausnehmung und dem zugehörigen Kathodenröhrchen-Teilelement ergibt.

## Patentansprüche

1. Hohlkathodensystem zum Erzeugen eines Plasmas, umfassend mindestens zwei Kathodenröhrchen (11a; 11b), eine Anodeneinrichtung (13), eine Stromversorgungseinrichtung (14) zum Bereitstellen einer zwischen den Kathodenröhrchen (11a; 11b) und der Anodeneinrichtung (13) geschalteten elektrischen Spannung und mindestens ein Gasreservoir (15) zum Bereitstellen eines die Kathodenröhrchen (11a; 11b) durchströmenden Gases, und wobei jedem Kathodenröhrchen (11a; 11b) ein separates Stellglied (17a; 17b) zugeordnet ist, mittels dessen die Menge des Gases, welches das dem Stellglied (17a; 17b) zugeordnete Kathodenröhrchen (11a; 11b) durchströmt, einstellbar ist, **dadurch gekennzeichnet, dass** die mindestens zwei Kathodenröhrchen (11a;11b) elektrisch leitfähig miteinander verbunden sind.

2. Hohlkathodensystem nach Anspruch 1, wobei die Rohrachsen (12a; 12b) der mindestens zwei Kathodenröhrchen (11a; 11b) parallel zueinander ausgerichtet sind oder einen Winkel von maximal 5° zueinander aufweisen.

3. Hohlkathodensystem nach Anspruch 1 oder 2, wobei die Gasflussrichtung durch die mindestens zwei Kathodenröhrchen (11a; 11b) gleich ist.

4. Hohlkathodensystem nach einem der vorhergehenden Ansprüche, wobei benachbarte Kathodenröhrchen (11a; 11b) einen Abstand von maximal 20 mm zueinander aufweisen.

5. Hohlkathodensystem nach einem der vorhergehenden Ansprüche, wobei zumindest ein Element (23) der Anodeneinrichtung ringförmig ausgebildet ist, wobei das zumindest eine Element (23) der Anodeneinrichtung die mindestens zwei Kathodenröhrchen (21a; 21b; 21c) umschließt.

6. Verfahren zum Betreiben eines Hohlkathodensystems, bei welchem eine Anodeneinrichtung (13), eine Stromversorgungseinrichtung (14) zum Bereitstellen einer zwischen mindestens zwei Kathodenröhrchen (11a; 11b) und der Anodeneinrichtung (13) geschalteten elektrischen Spannung und mindestens ein Gasreservoir (15) zum Bereitstellen eines der Kathodenröhrchen (11a; 11b) durchströmenden Gases verwendet werden, wobei jedem Kathodenröhrchen (11a; 11b) ein separates Stellglied (17a; 17b) zugeordnet wird, mittels dessen die Menge und/oder die Art des Gases, welches das dem jeweiligen Stellglied (17a; 17b) zugeordnete Kathodenröhrchen (11a; 11b) durchströmt, eingestellt wird, **dadurch gekennzeichnet, dass** die mindestens zwei Kathodenröhrchen (11a; 11b) elektrisch leitfähig miteinander verbunden werden.

7. Verfahren nach Anspruch 6, wobei zumindest bei einem ersten Kathodenröhrchen (11a) mittels eines ersten Stellgliedes (17a) eine das erste Kathodenröhrchen (11a) durchströmende erste Gasmenge eingestellt wird, welche zum Zünden einer Bogenentladung zwischen dem ersten Kathodenröhrchen (11a) und der Anodeneinrichtung (13) geeignet ist.

8. Verfahren nach Anspruch 7, wobei zumindest bei einem zweiten Kathodenröhrchen mittels eines zweiten Stellgliedes eine das zweite Kathodenröhrchen durchströmende zweite Gasmenge eingestellt wird, welche nicht zum Zünden einer Bogenentladung zwischen dem zweiten Kathodenröhrchen und der Anodeneinrichtung geeignet ist.

9. Verfahren nach Anspruch 6, wobei zumindest bei einem ersten Kathodenröhrchen (11a), bei welchem eine Bogenentladung zwischen dem ersten Kathodenröhrchen (11a) und der Anodeneinrichtung (13) ausgebildet ist, die Bogenentladung beendet wird und dass zumindest bei einem zweiten Kathodenröhrchen (11b), bei welchem keine Bogenentladung zwischen dem zweiten Kathodenröhrchen (11b) und der Anodeneinrichtung (13) ausgebildet ist, eine Bogenentladung gezündet wird.

10. Verfahren nach einem der Ansprüche 7 bis 9, wobei von mindestens zwei Kathodenröhrchen (11a; 11b) gleichzeitig eine Bogenentladung, mit für jedes Kathodenröhrchen separat einstellbarer Stromstärke, hin zur Anodeneinrichtung (13) aufrechterhalten wird.

11. Verfahren nach Anspruch 6, wobei mittels der separaten Stellglieder (17a; 17b) auch die Art des Gases, welches das dem jeweiligen Stellglied (17a; 17b) zugeordnete Kathodenröhrchen (11a; 11b) durchströmt, eingestellt wird.

## Claims

1. Hollow cathode system for generating a plasma, comprising at least two cathode tubes (11a; 11b), an anode device (13), a power supply device (14) for providing an electrical voltage applied between the cathode tubes (11a; 11b) and the anode device (13) and at least one gas reservoir (15) for providing a gas that flows through the cathode tubes (11a; 11b), and wherein each cathode tube (11a; 11b) is assigned a separate actuator (17a; 17b), by means of which the amount of gas that flows through the cathode tube (11a; 11b) assigned to the actuator (17a; 17b) can be set, **characterized in that** the at least two cathode tubes (11a; 11b) are electrically conductively connected to one another.

2. Hollow cathode system according to Claim 1, wherein the tube axes (12a; 12b) of the at least two cathode tubes (11a; 11b) are aligned parallel to one another or are at an angle to one another of no more than 5°.

3. Hollow cathode system according to Claim 1 or 2, wherein the direction of gas flow through the at least two cathode tubes (11a; 11b) is the same.

4. Hollow cathode system according to one of the preceding claims, wherein adjacent cathode tubes (11a; 11b) are at a distance from one another of no more than 20 mm.

5. Hollow cathode system according to one of the preceding claims, wherein at least one element (23) of the anode device is of an annular form, wherein the at least one element (23) of the anode device encloses the at least two cathode tubes (21a; 21b; 21c).

6. Method for operating a hollow cathode system in which an anode device (13), a power supply device (14) for providing an electrical voltage applied between at least two cathode tubes (11a; 11b) and the anode device (13) and at least one gas reservoir (15) for providing a gas that flows through the cathode tubes (11a; 11b) are used, wherein each cathode tube (11a; 11b) is assigned a separate actuator (17a; 17b), by means of which the amount and/or the type of gas that flows through the cathode tube (11a; 11b) assigned to the respective actuator (17a; 17b) is set, **characterized in that** the at least two cathode tubes (11a; 11b) are electrically conductively connected to one another.

7. Method according to Claim 6, wherein, at least for a first cathode tube (11a), a first amount of gas that flows through the first cathode tube (11a) and is suitable for igniting an arc discharge between the first cathode tube (11a) and the anode device (13) is set by means of a first actuator (17a).

8. Method according to Claim 7, wherein, at least for a second cathode tube, a second amount of gas that flows through the second cathode tube and is not suitable for igniting an arc discharge between the second cathode tube and the anode device is set by means of a second actuator.

9. Method according to Claim 6, wherein, at least for a first cathode tube (11a), for which an arc discharge is formed between the first cathode tube (11a) and the anode device (13), the arc discharge is ended and wherein, at least for a second cathode tube (11b), for which no arc discharge is formed between the second cathode tube (11b) and the anode device (13), an arc discharge is ignited.

10. Method according to one of Claims 7 to 9, wherein an arc discharge from at least two cathode tubes (11a; 11b) to the anode device (13) is maintained simultaneously with amperages that can be set separately for each cathode tube.

11. Method according to Claim 6, wherein the type of gas that flows through the cathode tube (11a; 11b) assigned to the respective actuator (17a; 17b) is also set by means of the separate actuators (17a; 17b).

## Revendications

1. Système à cathodes creuses pour la production d'un plasma, comprenant au moins deux tubes formant cathodes (11a ; 11b), un dispositif formant anode (13), un dispositif d'alimentation en courant (14), pour fournir une tension électrique appliquée entre les tubes formant cathodes (11a ; 11b) et le dispositif formant anode (13), et au moins un réservoir de gaz (15) pour fournir un gaz qui traverse les tubes formant cathodes (11a ; 11b), et un organe de réglage séparé (17a ; 17b) étant associé à chaque tube formant cathode (11a ; 11b), au moyen duquel la quantité de gaz qui traverse le tube formant cathode (11a ; 11b) associé à l'organe de réglage (17a ; 17b) est apte à être réglée, **caractérisé en ce que** lesdits au moins deux tubes formant cathodes (11a ; 11b) sont reliés entre eux de manière électriquement conductrice.

2. Système à cathodes creuses selon la revendication 1, dans lequel les axes de tubes (12a ; 12b) desdits au moins deux tubes formant cathodes (11a ; 11b) sont orientés parallèlement l'un à l'autre ou forment entre eux un angle de 5° au maximum.

3. Système à cathodes creuses selon la revendication 1 ou la revendication 2, dans lequel la direction du flux de gaz à travers lesdits au moins deux tubes formant cathodes (11a ; 11b) est la même.

4. Système à cathodes creuses selon l'une des revendications précédentes, dans lequel des tubes formant cathodes (11a ; 11b) voisins présentent une distance de 20mm maximum les uns par rapport aux autres.

5. Système à cathodes creuses selon l'une des revendications précédentes, dans lequel au moins un élément (23) du dispositif formant anode est de forme annulaire, ledit au moins un élément (23) du dispositif formant anode entourant lesdits au moins deux tubes formant cathodes (21a ; 21b ; 21c).

6. Procédé pour faire fonctionner un système à cathodes creuses, dans lequel sont utilisés un dispositif d'anode (13), un dispositif d'alimentation en courant (14), pour fournir une tension électrique appliquée entre au moins deux tubes formant cathodes (11a ; 11b) et le dispositif d'anode (13), et au moins un réservoir de gaz (15) pour fournir un courant électrique aux tubes formant cathodes (11a ; 11b), un organe de réglage séparé (17a ; 17b) étant associé à chaque tube formant cathode (11a ; 11b), au moyen duquel la quantité et/ou le type de gaz qui traverse le tube formant cathode (11a ; 11b) associé à l'organe de réglage respectif (17a ; 17b) est réglé, **caractérisé en ce que** lesdits au moins deux tubes formant cathodes (11a ; 11b) sont reliés entre eux de manière électriquement conductrice.

7. Procédé selon la revendication 6, dans lequel, au moins pour un premier tube formant cathode (11a), il est réglé, au moyen d'un premier organe de réglage (17a), une première quantité de gaz traversant le premier tube formant cathode (11a), qui est appropriée pour amorcer une décharge d'arc entre le premier tube formant cathode (11a) et le dispositif formant anode (13).

8. Procédé selon la revendication 7, dans lequel, au moins pour un deuxième tube formant cathode, il est réglé, au moyen d'un deuxième organe de réglage, une deuxième quantité de gaz traversant le deuxième tube formant cathode, qui n'est pas appropriée pour amorcer une décharge d'arc entre le deuxième tube formant cathode et le dispositif formant anode.

9. Procédé selon la revendication 6, dans lequel, au moins dans un premier tube formant cathode (11a), dans lequel une décharge d'arc est formée entre le premier tube formant cathode (11a) et le dispositif formant anode (13), la décharge d'arc est arrêtée, et, au moins dans un deuxième tube formant cathode (11b), dans lequel aucune décharge d'arc n'est formée entre le deuxième tube formant cathode (11b) et le dispositif formant anode (13), une décharge d'arc est amorcée.

10. Procédé selon l'une des revendications 7 à 9, dans lequel une décharge en arc, dont l'intensité de courant est réglable séparément pour chaque tube formant cathode, est entretenue simultanément par au moins deux tubes formant cathodes (11a ; 11b) en direction du dispositif formant anode (13).

11. Procédé selon la revendication 6, dans lequel, au moyen des organes de réglage séparés (17a ; 17b), il est réglé également le type de gaz qui traverse le tube formant cathode (11a ; 11b) associé à l'organe de réglage respectif (17a ; 17b).
